(19) Europäisches Patentamt
European Patent Office
Office européen des brevets

(11) **EP 2 221 881 A1**

(12) **EUROPEAN PATENT APPLICATION**

(43) Date of publication:
**25.08.2010 Bulletin 2010/34**

(51) Int Cl.:
***H01L 31/052*** *(2006.01)*

(21) Application number: **09425024.8**

(22) Date of filing: **28.01.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Progind S.r.L.**
**Azeglio (IT)**

(72) Inventor: **Arno, Valter**
**10010 Azeglio (IT)**

(74) Representative: **Bergadano, Mirko et al**
**Studio Torta S.r.l.**
**Via Viotti, 9**
**10121 Torino (IT)**

Remarks:
Amended claims in accordance with Rule 137(2) EPC.

(54) **System for irradiating photovoltaic cells with an electromagnetic radiation and photovoltaic module**

(57)    A system for irradiating photovoltaic cells (12) with an electromagnetic radiation is described, having a first supporting structure (21) for carrying a plurality of photovoltaic cells (12), and first focusing elements (23) for receiving and focusing the electromagnetic radiation. The system is further provided with a diffusing element (24) for receiving the electromagnetic radiation focused by the first focusing elements (23) and for reflecting the electromagnetic radiation; the supporting structure (21) and the diffusing element (24) are reciprocally arranged so that the electromagnetic radiation reflected by the diffusing element (24) is directed towards the plurality of photovoltaic cells (12).

FIG. 5

**Description**

The present invention relates to a system for radiating photovoltaic cells with an electromagnetic radiation and to a photovoltaic module.

As known, a photovoltaic cell, also known as a solar cell, is a broad area device capable of converting solar energy, i.e. the energy associated to an electromagnetic radiation emitted by the Sun, into electricity.

In detail, a traditional type photovoltaic cell comprises a thin layer of semiconductor material (e.g. silicon Si, cadmium telluride CdTe, or copper indium selenide CuIS) doped in order to form a p-n junction, and thus has an n-type region and a p-type region, generally arranged one over the other. The layer of semiconductor material has a thickness generally in the order of 200-250$\mu$m, and presents an upper surface and a lower surface, on which two metallization regions (electrodes) are arranged, so as to form corresponding ohmic metallic-semiconductor contacts.

In use, the photovoltaic cell is generally arranged so that the electromagnetic radiation is incident on the upper surface with a direction of incidence as perpendicular as possible to the upper surface itself.

When the electromagnetic radiation incides on the upper surface of the photovoltaic cell, i.e. when the photons associated to the electromagnetic radiation incide on the upper surface, a first number of photons is reflected, a second number of photons pass through the photovoltaic cell, while the remaining photons are absorbed by the layer of semiconductor material. Whether a photon is absorbed or not depends on the ratio existing between the energy possessed by the photon and the energy gap, or bandgap, which characterizes the semiconductor material: the photon is absorbed if its energy is higher than the bandgap.

When a photon is absorbed, electron-hole pairs, i.e. charge carriers (also known as carriers, for short) are generated, which may be collected by an appropriate external circuitry, electrically connected to the electrodes of the photovoltaic cell so as to form a closed circuit. Therefore, in presence of electromagnetic radiation inciding on the upper surface of the photovoltaic cell, a current flows along such circuit; furthermore, a potential difference is established between the electrodes.

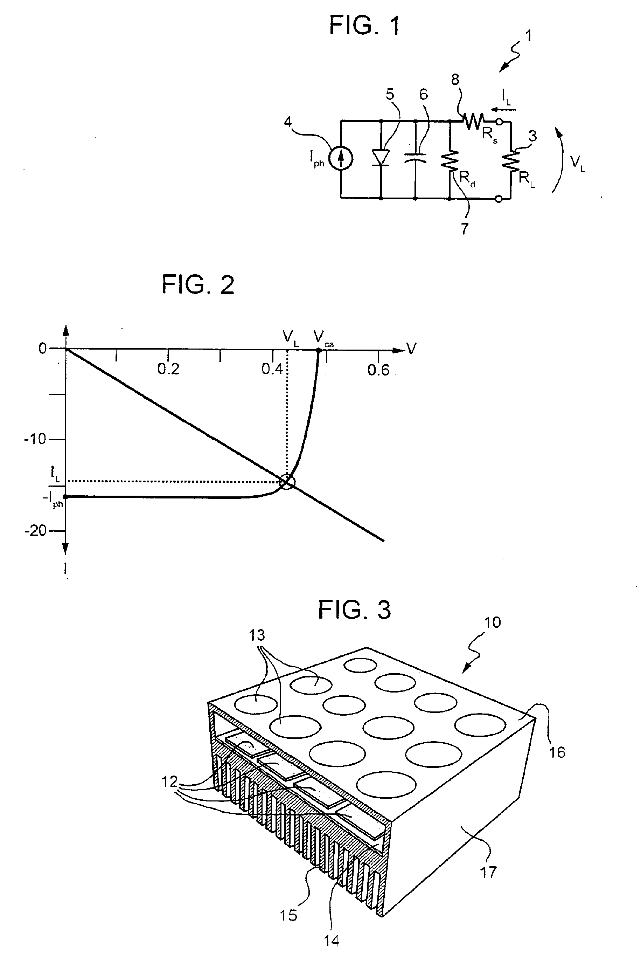

By way of example, Figure 1 shows an equivalent electric circuit 1 which models a photovoltaic cell, to the electrodes of which a resistive type load 3, with resistance equal to $R_L$, is connected. The voltage which is established at the nodes of the load $R_L$ is indicated by $V_L$, while the current which passes through the nodes is indicated by $I_L$; without loosing in generality, the directions of such voltage $V_L$ and current $I_L$ are assumed according to the convention of generators.

In detail, the photovoltaic cell is modelled by a current generator 4, by a diode 5, by a junction capacitor 6 and by a junction resistor 7 connected in parallel, and furthermore by a contact resistor 8, arranged in series to the parallel circuit formed by the current generator 4, by the diode 5, by the junction capacitor 6 and by the junction resistor 7. The resistance of the junction resistor 7 and the contact resistor 8 is equal to $R_d$ and $R_s$, respectively.

The current generator 4 generates a photogenerated current $I_{ph}$, proportional to the power associated to the electromagnetic radiation which is incident on the photovoltaic cell, hereinafter named incident power $P_{in}$. In detail, by indicating with letter A the area of the photovoltaic cell, i.e. the upper surface area, and assuming that the electromagnetic radiation has a power density (also known as light density, or radiation) uniformly distributed on the upper surface and equal to dP/dS, and further assuming that the electromagnetic radiation incides perpendicularly to such upper surface, the incident power $P_{in}$ is equal to the product dP/dS*A.

The diode 5 represents an ideal diode, while the junction capacitor 6 and the junction resistor 7, respectively, represent the capacitance and the resistance of the PN junction of the photovoltaic cell. Finally, the contact resistor 8 represents the resistance present between the electrodes and the semiconductor material; it is generally negligible.

Figure 2 shows a voltage-current characteristic of a photovoltaic cell, and specifically shows the trend of such characteristic in the fourth quadrant on the current (I)-voltage (V) plane, for the sake of brevity also known as I-V plane. In the voltage-current characteristic, a first and a second point are present, identified by the pairs of coordinates $(-I_{ph},0)$ and $(0,V_{ca})$, which represent the current $I_L$ and voltage $V_L$ values, in the case in which the load 3 is a short circuit, or an open circuit, respectively. Specifically, in case of short circuit, the voltage $V_L$ is zero, and the current $I_L$ is equal to $-I_{ph}$, i.e. equal in modulus to the photogenerated current, which, as mentioned, depends on the incident power $P_{in}$. On the other hand, in case of open circuit, the current $I_L$ is zero, while the voltage $V_L$ assumes a value equal to $V_{ca}$.

Given the voltage-current characteristic shown in Figure 2, thus given the photovoltaic cell the voltage-current characteristic thereof is shown, and given an incident power value $P_{in}$, and given the resistive type load 3 with resistance equal to $R_L$, the voltage $V_L$ and the current $I_L$ are given by the intersection of the voltage-current characteristic with the line which passes through the origin of the I-V plane and has a slope equal to $-1/R_L$. In the case shown in Figure 2, the maximum electric power $P_{max}$ that the photovoltaic cell can deliver is given by the product $I_{ph}*V_{ca}$, while the electric power Pout actually delivered by the photovoltaic cell to the load 3 is equal to the product $V_L*I_L$. Therefore, the photovoltaic cell has an efficiency $\eta$ equal to the ratio $P_{out}/P_{in}$; furthermore, it presents a filling factor (FF) given by the ratio $P_{out}/P_{max}$.

In general, the photovoltaic cells known today have an efficiency comprised in the 8-16% range, and a filling factor comprised in the 60-75% range.

In order to improve efficiency, so-called multi-junction photovoltaic cells have been suggested, typically formed by gallium arsenide (GaAs).

A multi-junction photovoltaic cell comprises several vertically arranged p-n junctions, so that, in use, the electromagnetic radiation which is incident on the multi-junction cell passes through such p-n junctions, thus allowing to reach efficiencies in the order of 40%.

Given the low electric power values $P_{out}$ which can be obtained by a single photovoltaic cell, either of the traditional or of the multi-junction type, so-called photovoltaic modules, i.e. groups of electrically connected photovoltaic cells, are used. Generally, in turn, several photovoltaic modules are electrically connected in series, so as to form a so-called photovoltaic module string.

For practical purposes, so-called photovoltaic generators, also known as photovoltaic plants, are used to generate high amounts of electricity. In detail, a photovoltaic generator is formed by connecting several photovoltaic modules in parallel. The number and electric connections of the photovoltaic cells of the photovoltaic modules, as well as the number of photovoltaic modules of the strings and the number of the strings themselves, are chosen so that the photovoltaic generator delivers, when in use, the desired voltage $V_L$ and current $I_L$.

The photovoltaic generators are distinguished into passive type photovoltaic generators and concentration photovoltaic generators, according to whether they use traditional type photovoltaic cells or multi-junction type photovoltaic cells. Furthermore, in concentration photovoltaic generators, each photovoltaic cell is associated to a corresponding optical system, typically formed by a lens, arranged with respect to the photovoltaic cell so as to be, in use, interposed between the photovoltaic cell and the incident electromagnetic radiation (e.g. from the Sun).

In detail, a concentration photovoltaic generator comprises at least one photovoltaic module of the type schematically shown in Figure 3. Such a photovoltaic module, here indicated with 10, is formed by a photovoltaic cell matrix of the multi-junction type, here indicated with 12, arranged on a flat support 14 so as to form a planar photovoltaic cell matrix 12. A heat sink 15 is arranged under the flat support 14, and in direct contact therewith. A corresponding Fresnel lens 13 is arranged over each photovoltaic cell 12, so that a corresponding flat Fresnel lens matrix is arranged over the flat photovoltaic cell matrix 13. In the illustrated photovoltaic module 10, the Fresnel lens 13 are formed by a plastic material monolithic layer 16, carried by a frame 17, e.g. formed by metallic material coated by plastic material, connected to the flat support 14.

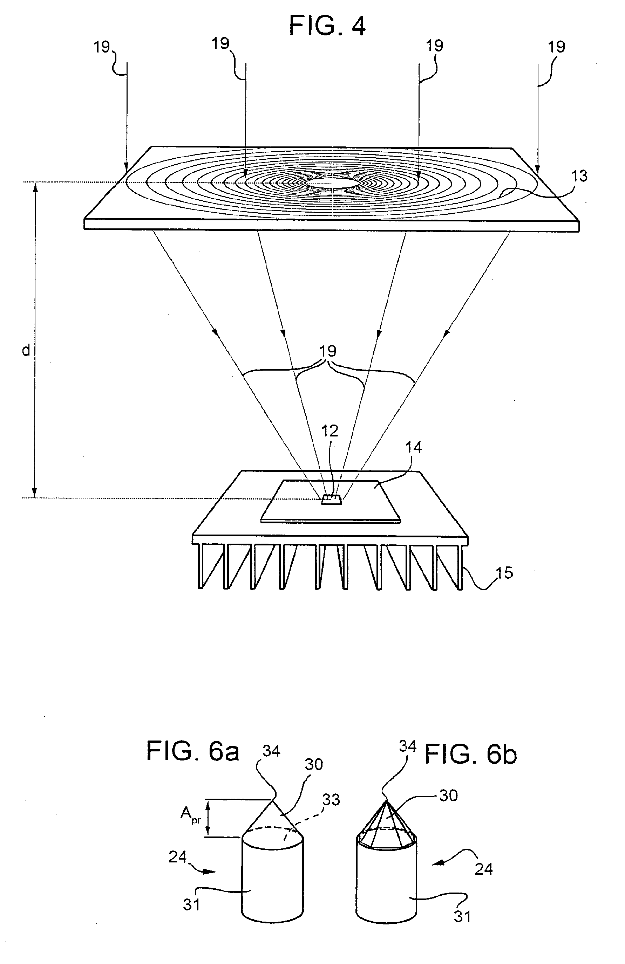

Figure 4 shows in detail a photovoltaic cell 12, having area A, and a corresponding Fresnel lens 13, having area $A_l$, wherein the Fresnel lens 13 is aligned with respect to the photovoltaic cell 12. The frame 17 (not shown in Figure 4) is dimensioned so that the distance d between the Fresnel lens 13 and the photovoltaic cell 12 is such that the electromagnetic radiation (schematically indicated by the optical rays 19), which incides on the Fresnel lens 13, is focused by the Fresnel lens 13 on the photovoltaic cell 12, and specifically on the area A of the photovoltaic cell 12. For practical purposes, the distance d depends on the focal length f of the Fresnel lens 13 and on the area A of the photovoltaic cell 12.

Operatively, and assuming that the electromagnetic radiation incident on the Fresnel lens 13 has a power density still equal to dP/dS, the Fresnel lens 13 conveys an incident power $P_{in}$ equal to the product dP/dS*$A_l$, thus proportional to the area of the Fresnel lens 13, onto the photovoltaic cell 12. Equivalently, the electromagnetic radiation 19 incides on the photovoltaic cell 12 with increased power density, with respect to the power with which it incides on the Fresnel lens 13, by a factor (optical gain) equal to the ratio between the area $A_l$ of the Fresnel lens 13 and the area A of the photovoltaic cell 12.

Therefore, with respect to the passive type photovoltaic modules, photovoltaic cells 12 with reduced area A can be used in concentration type photovoltaic modules, with consequent reduction of costs associated to the semiconductor, such a reduction of the area of the semiconductor being compensated by the optical gain introduced by the Fresnel lens 13.

It is worth noting that, although explicit reference is made to Fresnel lens, photovoltaic modules are known which use different optical devices instead of Fresnel lenses, which will be generally referred to hereinafter as concentrator devices, such as for example: prismatic lenses, optical meniscuses, waveguide concentrators or parabolas in various configurations (e.g. Cassegrain configuration).

Independently from the type of photovoltaic cell and from the type of concentrator devices used, the photovoltaic modules are characterized by means of a parameter known as peak power $W_p$, equal to the product of the maximum power current $I_{pm}$ and the maximum power voltage $V_{pm}$, i.e. the short-circuit current and the open circuit voltage generated by the considered photovoltaic module when used in the following conditions: temperature equal to 25°C, electromagnetic radiation inciding on the photovoltaic cells with power density equal to 1000W/m$^2$, and air mass parameter equal to 1.5, such a parameter being indicative of the attenuation introduced by the atmosphere on the electromagnetic radiation generated by the Sun.

Furthermore, the photovoltaic modules have an efficiency $\eta_m$ which is given by the equation:

$$\eta_m = \frac{P_{out\_m}}{A_m \times dP/dS} \quad (1)$$

wherein $A_m$ represents the overall area of the photovoltaic module, given by the sum of the areas A of the photovoltaic cells, dP/dS is the density of the electromagnetic radiation power which incides on the photovoltaic module (assumed as uniformly distributed on the area $A_m$ of the photovoltaic module) and $P_{out\_m}$ is the electrical power output by the photovoltaic module. For concentration photovoltaic modules, the efficiency $\eta_m$ is of approximately 30-40%.

Although the concentration type photovoltaic modules of the known type are very efficient and allow to reduce the area of semiconductor material exposed to incident radiation, they however have large size, comparable to the dimensions of passive type photovoltaic modules. Indeed, concentration photovoltaic modules are based on a matrix geometry obtained by replicating a fundamental unit (the photovoltaic cell-concentrator device pair) on a portion of a plane. The large dimensions thus make the current concentration photovoltaic modules, and therefore the photovoltaic generators which use them, unsuitable for domestic type use, such as for example for supplying electricity to a home.

It is the object of the present invention to make a system for irradiating photovoltaic cells with an electromagnetic radiation and a photovoltaic module which allow to at least in part solve the drawbacks of the known art, and, specifically, which allow to obtain a reduction in dimensions.

According to the invention, a system for irradiating photovoltaic cells with an electromagnetic radiation, a photovoltaic module and a method for irradiating photovoltaic cells with an electromagnetic radiation are therefore provided, as disclosed in claims 1, 13 and 17 respectively.

For a better understanding of the invention, embodiments thereof will be described hereafter only by way of non-limitative example, and with reference to the accompanying drawings, in which:

- Figure 1 shows an equivalent circuit diagram of a photovoltaic cell;
- Figure 2 shows a voltage-current characteristic of a photovoltaic cell, related to the fourth quadrant of a current (I) - voltage (V) plane;
- Figure 3 schematically shows a perspective view of a photovoltaic module of known type;
- Figure 4 shows a functional diagram of the elements of the photovoltaic module shown in Figure 3;
- Figure 5 shows an axonometric view of a photovoltaic module according to the invention;
- Figures 6a, 6b show two possible variants of a diffusing element belonging to the module in Figure 5;
- Figure 7 shows a functional diagram of the elements of the photovoltaic module shown in figure 5;
- Figure 8 shows an axonometric section of a further embodiment of a photovoltaic module according to the present invention; and
- Figure 9 shows a top view of a portion of a variant of the photovoltaic module according to the invention.

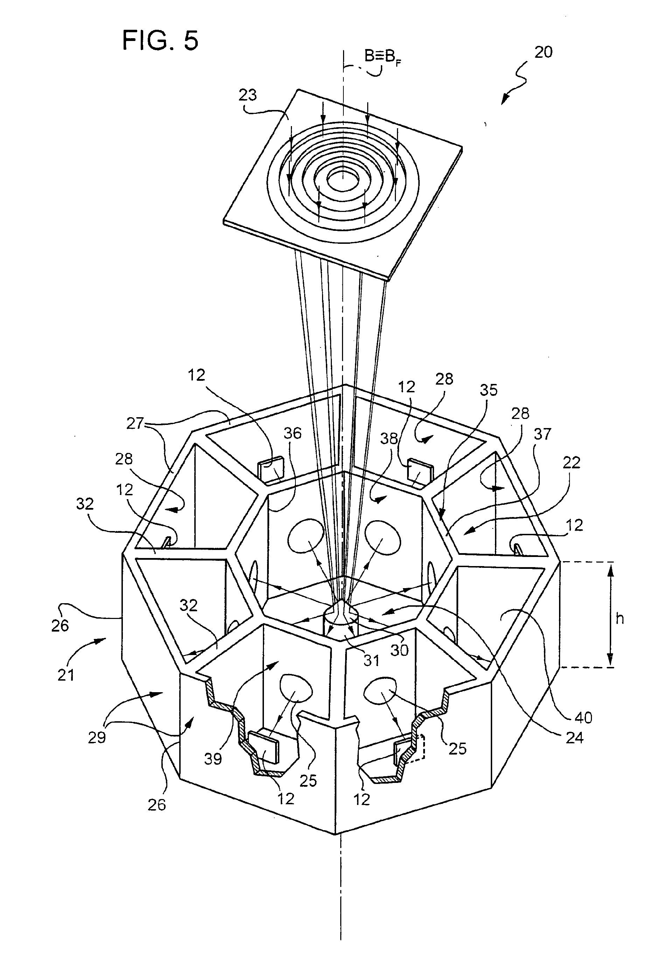

As shown in Figure 5, a photovoltaic module 20 according to an embodiment of the present invention comprises: a supporting structure 21; a confining structure 22; a first focusing device, in the case in point formed by a Fresnel lens 23; a diffusing element 24; a plurality of photovoltaic cells, indicated again with 12, equal to eight in number in the example shown, and a corresponding plurality of second focusing devices, in the case in point consisting of focusing lenses 25, again equal to eight in number in the example.

In detail, the supporting structure 21, formed, for example, by aluminium embedded in a mixture of Teflon and talc (or Teflon and mica), is shaped as an octagonal base prism, in the example shown, and presents a symmetry axis B, arranged vertically in the sense of height, indicated by h, side edges 26, parallel to the symmetry axis B, and side walls 27; each side wall 27 presents an internal surface 28 and an external surface 29.

The diffusing element 24 is arranged inside the supporting structure 21, and extends along the symmetry axis B. The diffusing element 24 comprises a reflecting portion 30 and a supporting portion 31, and is arranged so that the reflecting portion 30 faces the Fresnel lens 23, in use. As shown in greater detail in Figure 6a, the supporting portion 31 has a cylindrical shape, while the reflecting portion 30 has a conical shape, with a base 33, a vertex 34 and a height $a_{pr}$; furthermore, the symmetry axis of the reflecting portion 30 coincides with the symmetric axis B. Embodiments in which the diffusing element 24 has a different shape are however possible; for example, as shown in Figure 6b, a diffusing element 24 may be used which comprises a polygonal base pyramid shaped reflecting portion 30, with a number of side faces equal to the number of side walls 27 of the supporting structure 21 (in the example, having the shape of an octagonal pyramid).

Regardless of the adopted geometric shape, the reflecting portion 30 is formed by a material with a low thermal conductivity and a low thermal expansion coefficient (e.g. ceramic material containing mica, such as Mikroy/Micalex™), and is coated with a layer of reflecting material (e.g. aluminium or gold), adapted to reflect the incident electromagnetic radiation. The supporting portion 31 may also be formed by ceramic material.

The Fresnel lens 23 is arranged over the supporting structure 21, and presents an optical axis $B_F$ aligned with the symmetry axis B; therefore, it is arranged over the diffusing element 24, so as to concentrate the electromagnetic radiation on the reflecting portion 30. The means used to maintain the Fresnel lens 23 in position is irrelevant for the purposes of the present invention,; e.g. a specific frame (not shown) may be used connected to the supporting structure 21, or the Fresnel lens 23 may be integrated in a cover (not shown) adapted to be arranged over the supporting structure 21. Preferably, in general, the Fresnel lens 23 is releasably coupled to the corresponding frame or cover, in order to be conveniently replaced with a different lens, according to needs.

The photovoltaic cells 12 are of the multi-junction type, are - for example - square shaped and are arranged - for example - by means of a specific mechanical support (not shown), which allows the replacement thereof, on corresponding internal surfaces 28 of the side walls 27 of the supporting structure 21, so as to receive the electromagnetic radiation after being reflected by the diffusing element 24, in the case in point by the reflecting portion 30. Specifically, in the illustrated embodiment, the photovoltaic cells 12 are equally spaced out in the angular direction, equally distanced from the symmetry axis B and at a same height with respect to the plane on which the base of the supporting structure 21 lays.

From the electric point of view, the photovoltaic cells 12 are connected, in a per se known manner, according to the use contemplated for the photovoltaic module 20, and specifically according to the required voltage and current. By way of example only, appropriate electric circuits (not shown) may be used to electrically connect the illustrated eight photovoltaic cells 12, so as to form a parallel of two series of four photovoltaic cells 12.

Each focusing lens 25 is arranged, as described in detail below, so as to be interposed between the diffusing element 24 and a corresponding photovoltaic cell 12. Operatively, the electromagnetic radiation, after being reflected by the diffusing element 24, is focused again by the focusing lenses 25 in direction of the photovoltaic cells 12, so as to maximize the power density of the electromagnetic radiation which incides on the photovoltaic cells 12 themselves.

The confining structure 22 is made inside the supporting structure 21 and surrounds the diffusing element 24. In detail, the confining structure 22, formed - for example - by aluminium embedded in a mixture of Teflon and talc, comprises an internal body 35 and radial walls 32 extending from the internal body 35.

The internal body 35 has a shape corresponding to that of the supporting structure 21, an octagonal based prism in the example shown, such an octagonal base being coplanar with, and contained within, the octagonal base of the supporting structure 21. Therefore, the internal body 35 presents eight side walls 37 and eight edges 36, and has height equal to the height h of the supporting structure 21. Each side wall 37 has an internal surface 38 (facing the symmetry axis B) and an external surface 39, and furthermore carries a focusing lens 25, which is integrated in the side wall 37 itself.

Furthermore, the internal body 35 is arranged coaxially with respect to the supporting structure 21, and is angularly arranged with respect to the symmetry axis B so that the edges 36 of the internal structure 35 itself and the edges 26 of the supporting structure 21 are coplanar two-by-two with the longitudinal axis h.

Each radial wall 32 extends between a corresponding pair of edges 26, 36 of the supporting structure 21 and the internal structure 35 in radial direction with respect to the symmetry axis B.

In this manner, the internal body 35, the supporting structure 21 and the radial walls 32 form a plurality of cavities 40 (equal to eight in number in the case in point), the function of which is to avoid the dispersion of electromagnetic radiation focused by the focusing lenses 25 by directing the electromagnetic radiation possibly reflected by the photovoltaic cells 12 and the internal surfaces 28 of the supporting structure 21 back towards the photovoltaic cells 12. In order to perform this function better, the external surfaces 39 of the internal body 35 (except for where the focusing lenses 25 are present), the radial walls 32 and the internal surfaces 28 of the side walls 27 of the supporting structure 21 (except for where photovoltaic cells 12 are present) may be coated with reflecting material.

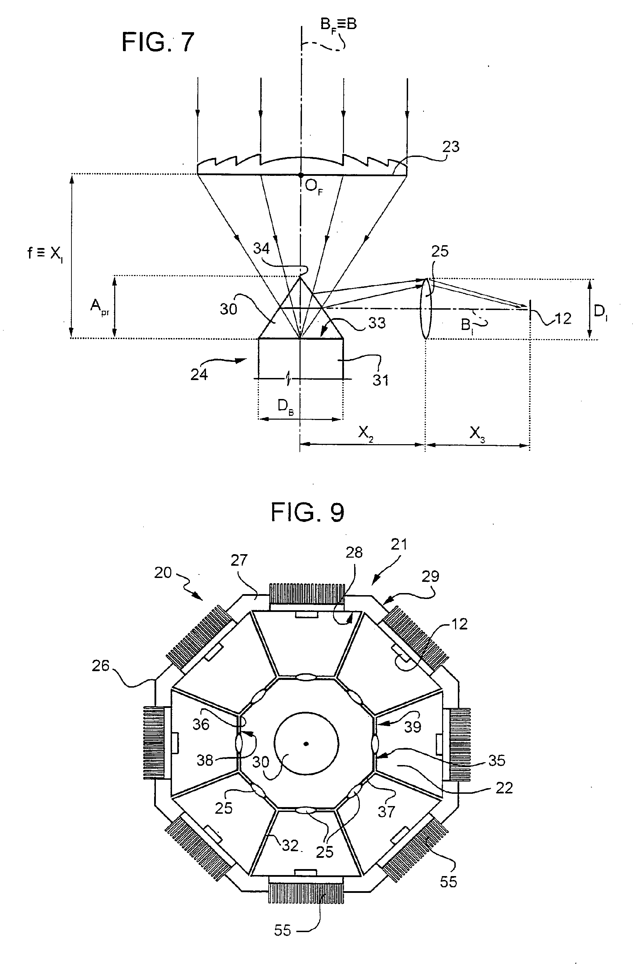

The arrangement of the Fresnel lens 23, of the diffusing element 24, of the focusing lenses 25 and of the photovoltaic cells 12 inside the photovoltaic module 20 is shown in greater detail in Figure 7, which shows only one photovoltaic cell 12 and the focusing lens 25 operatively coupled thereto by way of example.

The Fresnel lens 23 is placed at a distance from the diffusing element 24 such that the focus plane of the Fresnel lens 23 contains the base 33 of the reflecting portion 30 of the diffusing element 24. In other words, by indicating with letter f the focus length of the Fresnel lens 23 and with letter $x_1$ the distance between the optical centre OF of the Fresnel lens 23 and the base 33 of the reflecting portion 30, it results that $x_1=f$.

The focusing lens 25, for example, has a diameter $D_l$ equal to the height $a_{pr}$ of the reflecting portion 30. Furthermore, the focusing lens 25 and the corresponding photovoltaic cell 12 are arranged so that the optical axis $B_l$ of the focusing lens 25 is parallel to the base 33 of the reflecting portion 30, passes through the geometric centre of the corresponding photovoltaic cell 12 and intersects the symmetry axis B at mid height $a_{pr}$ of the reflecting portion 30. By measuring along the optical axis $B_l$ of the focusing lens 25, the focusing lens 25 has a distance $x_2$ from the symmetry axis B, while the photovoltaic cell 12 has a distance of $x_3$ from the focusing lens 25.

By indicating with $P_{in\_m}$ the power associated to the electromagnetic radiation inciding on the Fresnel lens 23, and thus entering in the photovoltaic module 20, and with $P_{in\_cf}$ the fraction of the power $P_{in\_m}$ inciding on a single photovoltaic cell 12, the diameter $D_b$ of the base 33 is dimensioned so as to minimize the loss introduced by the diffusing element 24, i.e. to maximize the power fraction $P_{in\_m}$ inciding on the reflecting portion 30, while the distances $x_2$ and $x_3$ are dimensioned so as to convey the electromagnetic radiation reflected by the diffusing element 24 towards the photovoltaic cells, so as to maximize $P_{in\_cf}$.

Specifically, in order to minimize the losses introduced by the diffusing element 24, the diameter $D_b$ is chosen, in a per se known manner, so that the entire electromagnetic radiation focused by the Fresnel lens 23 ideally incides on the reflecting portion 30. For example, the distribution of the electromagnetic radiation on the focus plane of the Fresnel lens 23 can be determined on the basis of two parameters: the size of the Airy disk and the Field of View (FoV), defined as $2.44*\lambda+R_f$ and $f*\theta$, respectively; in which $\lambda$ is a considered wavelength, typically equal to 550nm (corresponding to the maximum sensitivity of the human eye), $\theta$ is the apparent angle of the solar disc visible from the Earth (approximately 30 minutes of an arc), while $R_f$ and $f$ are the focus ratio and the focus length of the Fresnel lens 23, respectively. After having determined the aforesaid parameters, the dimension of the diameter $D_b$ can be determined so that is higher than the highest of the two parameters.

With regards to distances $x_2$ and $x_3$, the distance $x_2$ is such that it optimizes the amount of electromagnetic radiation reflected by the reflecting portion 30 collected by the focusing lens 25, while the distance $x_3$ is approximately equal to the focus distance $f_l$ of the focusing lens 25.

It is worth noting that the distances $x_1$, $x_2$ and $x_3$, as well as the position of the focusing lenses 25 and of the photovoltaic cells 12 with respect to the reflecting portion 30 may be different from that shown in Figures 5 and 7. For example, different embodiments are possible, in which the distance $x_1$ is different from the focus length $f$ of the Fresnel lens 23, so that the relation $x_1-a_{pr}<f<x_1$ applies, i.e. the distance $x_1$ is such that the focus plane of the Fresnel lens 23 is between the base 33 and the vertex 34 of the reflecting portion 30.

In general, the aforesaid distances $x_1$, $x_2$ and $x_3$ may be also determined on the basis of practical tests, and in a per se known manner, in order to maximize the $P_{in\_cf}/P_{in}$ ratio. The dimensions of the supporting structure 21 and of the confining structure 22 vary as a consequence.

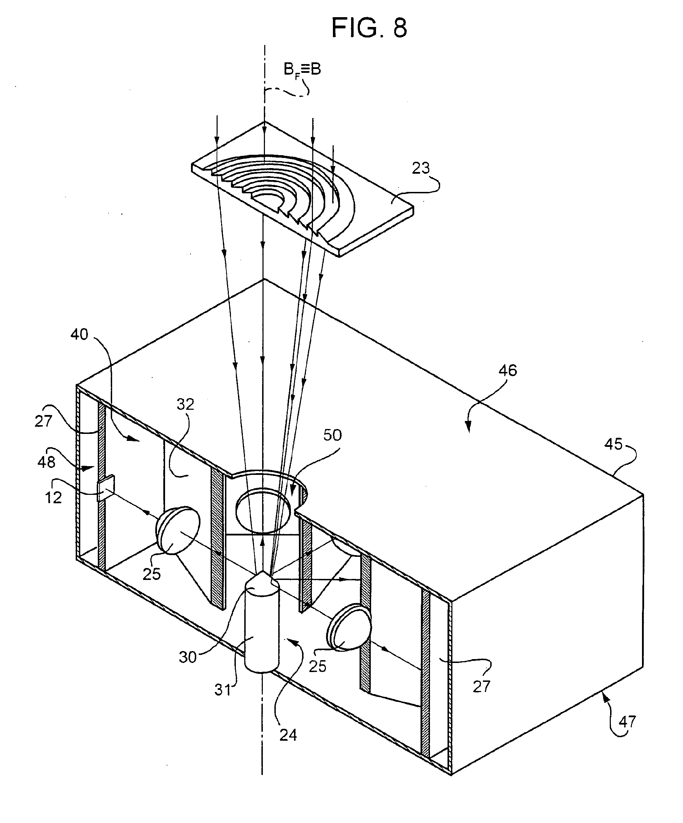

Figure 8 shows an embodiment in which the photovoltaic module 20 further comprises a container 45, which is parallelepiped shaped, encompasses the supporting structure 21, and presents an upper wall 46 and a lower wall 47. The Fresnel lens 23 is, for example, external to the container 45, and the upper wall 46 presents a hole 50, centred on the symmetry axis B and adapted to allow the electromagnetic radiation focused by the Fresnel lens 23 to enter into the container 45. Furthermore, since the aforesaid lower and upper walls 46, 47 inferiorly and superiorly delimit the cavities 40, they are internally coated with reflecting material, so that the cavities 40 are as delimited by reflecting surfaces as possible. A gap 48 is defined between the side walls 27 of the supporting structure 21 and the side walls of the container 45. A liquid may flow inside the gap 48, such as for example glycol propylene acting as heat exchanger with the external world.

The photovoltaic module 20 may be connected to a suitable heat pump, in order to allow an effective reuse of the heat which is generated inside the photovoltaic module 20 itself during use, specifically in proximity of the photovoltaic cells 12, on which most of the electromagnetic radiation is concentrated.

By way of pure example, Figure 9 shows a top view of a photovoltaic module 20, which, with respect to the previously illustrated embodiments, comprises a heat sink 55 for each photovoltaic cell 12. In detail, each side wall 27 of the supporting structure 21 is formed at least in part by a corresponding heat sink 55, e.g. formed by metallic material and of a per se known type, on which the corresponding photovoltaic cell 12 is arranged. Furthermore, a liquid-to-liquid heat pump (or exchanger) may be connected to the heat sinks so that the photovoltaic module 20 works as a co-generating system, i.e. is able to provide both electricity and hot water.

In virtue of its small size, the present photovoltaic module 20 may be equipped with tracking means of a known-type, having the function of orienting the photovoltaic module 20 so that the electromagnetic (solar) radiation incides on the Fresnel lens 23 in a direction as parallel as possible to the symmetry axis B (normal direction). For example, the photovoltaic module 20 may be equipped with a tracking system of the type commonly used in the field of astronomy (formed by an electric motor and appropriate actuators), so that the photovoltaic module 20 tracks the apparent motion of the Sun.

The described system for irradiating photovoltaic cells with an electromagnetic radiation and the described photovoltaic module are able to obtain advantages that clearly emerge from the previous description.

Specifically, given a predetermined power $P_{in\_m}$ which incides on the Fresnel lens 23, the photovoltaic module 20 allows to illuminate a plurality of photovoltaic cells 12, while maintaining contained dimension with respect to the concentration photovoltaic modules of the known type. Therefore, it may be advantageously used to provide electricity to a small consumer, e.g. domestic, in which application the spaces to be dedicated to a photovoltaic system are limited. Indeed, the present photovoltaic module is small in size (e.g. the supporting structure 21 may be inscribed in a circumference with a diameter equal to 15 cm and may have a height h equal to 5 cm) and may be easily positioned in proximity of a home. Furthermore, when equipped with a heat pump, the photovoltaic module 20 allows to provide home with hot water which can be used by common domestic consumers. Alternatively, the photovoltaic module 20 may be associated to a traditional type photovoltaic plant and work as a booster circuit.

Since the electricity supplied by the photovoltaic module 20 depends on the electromagnetic radiation collected by the Fresnel lens 13, the Fresnel lens 13 may be modified alone if the aforesaid electricity needs to be varied. For example, if more electricity is required, a Fresnel lens 13 having larger diameter may be used, so as to collect more electromagnetic radiation (higher power $P_{in\_m}$), without the need to further modify the photovoltaic module 20. Similarly, the electric connections between the photovoltaic cells 12 may be varied, in a per se known manner according to the contemplated use, so as to fulfil the voltage and current requirements required from the photovoltaic module 20.

It is finally apparent that changes and variations may be made to that here described and illustrated without departing from the scope of the present invention.

Firstly, embodiments in which the supporting structure 21 has a different polygonal base (not octagonal) are possible. Also in these embodiments, the number of side walls 27 preferably coincides with the number of photovoltaic cells 12 present in the module itself, although other embodiments are possible, in which one or more side walls 27 do not carry any photovoltaic cell 12. Similarly, the supporting structure 21 may be different, e.g. cylindrical.

Furthermore, embodiments are possible in which instead of a Fresnel lens the first focusing device consists of a different type of lens, such as a prismatic lens, an optical meniscus, or a primary-secondary optical assembly, for example in Cassegrain configuration, the primary being formed by a parabolic mirror with concavity facing towards the Sun and the secondary being arranged facing the primary so as to convey the electromagnetic radiation towards the diffusing element 24.

Similarly, the second focusing devices may be of a different type (traditional spherical lenses, field flattening lenses, etc.), or may be substituted by waveguide structures, such as conical waveguides, adapted to focus the electromagnetic radiation reflected by the diffusing element 24 on the photovoltaic cells 12.

With regards to the diffusing element 24, the reflecting portion 30 may have a different shape from those described, although preferably the number of side faces of the reflecting portion 30 itself is equal to the number of side walls 27 of the supporting structure 21. For example, it is possible to use a reflecting portion 30 formed by side surfaces which are concave, and not flat, with concavity facing towards the corresponding focusing lens 25, so as to convey as much electromagnetic radiation as possible toward the focusing lens 25.

Finally, the photovoltaic cells 12 may also be different from those of the multi-junction type, although this may imply a reduction in the overall performances of the photovoltaic module.

**Claims**

1. A system for irradiating photovoltaic cells (12) with an electromagnetic radiation, comprising a first supporting structure (21) configured to carry a plurality of photovoltaic cells (12), and first focusing means (23) configured to receive and focus said electromagnetic radiation,
   **characterized in that** it further comprises a diffusing element (24), configured to receive the electromagnetic radiation focused by said first focusing means (23) and to reflect said electromagnetic radiation, said supporting structure (21) and said diffusing element (24) being reciprocally arranged so that the electromagnetic radiation reflected by said diffusing element (24) is directed towards said plurality of photovoltaic cells (12).

2. A system according to claim 1, wherein said supporting structure (21) at least partially surrounds said diffusing element (24) and comprises a plurality of supporting elements (27), each configured to carry a corresponding photovoltaic cell (12) of said plurality; said supporting elements (27) being arranged around said diffusing element (24).

3. A system according to claim 1 or 2, wherein said first focusing means (23) have an optical axis ($B_F$), and wherein said diffusing element (24) comprises a reflecting portion (30) configured for reflecting electromagnetic radiation, said reflecting portion (30) having a symmetry axis (B), essentially coinciding with said optical axis.

4. A system according to claim 3, wherein said first focusing means (23) have a focus plane, and said diffusing element (24) is placed at a distance ($x_1$) from said first focusing means (23) so that said focus plane crosses said reflecting portion (30).

5. A system according to claim 3 or 4, wherein said reflecting portion (30) has a shape chosen between: cone and polygonal based pyramid.

6. A system according to any of the claims from 3 to 5, wherein said reflecting portion (30) is formed by a ceramic material and is coated with a material chosen between aluminium and gold.

7. A system according to any of the preceding claims, wherein said first supporting structure (21) presents a symmetry axis (B) and is configured to carry said plurality of photovoltaic cells (12) so that said photovoltaic cells are angularly equally-spaced and equidistant from said symmetry axis.

8. A system according to any of the preceding claims, further comprising second focusing means (25), configured to receive and focus the electromagnetic radiation reflected by said diffusing element (24), said second focusing means (25) and said supporting structure (21) being reciprocally arranged so that the electromagnetic radiation focused by said second focusing means (25) is directed towards said plurality of photovoltaic cells.

9. A system according to claim 8, further comprising a second supporting structure (22), configured to carry said second focusing means (25) so that they are arranged between said diffusing element (24) and said supporting structure (21).

**10.** A system according to claim 9, wherein said first (21) and second (22) supporting structures are configured so that said photovoltaic cells (12) essentially lay on focus planes of said second focusing means (25).

**11.** A system according to claim 9 or 10, wherein said first (21) and second (22) supporting structures define cavities (40) coated with a reflecting material and each accommodating a corresponding photovoltaic cell (12) of said plurality.

**12.** A system according to any of the claims 8-11, wherein said second focusing means (23) comprise any of: focusing lenses, field flattening lenses or waveguides; and wherein said first focusing means (23) comprise any of: a Fresnel lens, a prismatic lens, an optical meniscus.

**13.** A photovoltaic module (20) comprising: a system for irradiating photovoltaic cells (12) with an electromagnetic radiation according to any of the preceding claims, and a plurality of photovoltaic cell (12) carried by said system.

**14.** A photovoltaic module according to claim 13, wherein said photovoltaic cells (12) are of the multi-junction type.

**15.** A photovoltaic module according to claim 13 or 14, further comprising a container (45), said first supporting structure (21) being arranged inside said container (45) so that a gap (48) is present between said first supporting structure and said container, said gap being configured to contain a liquid.

**16.** A photovoltaic module according to claim 13 or 14, further comprising a plurality of heat sinks (55) and a heat pump, each heat sink being associated to a corresponding photovoltaic cell (12) of said plurality of photovoltaic cells, and said heat pump being operatively coupled to said heat sinks (55).

**17.** A method for irradiating photovoltaic cells (12) with an electromagnetic radiation, comprising the step of:

- arranging first focusing means (23) for receiving and focusing said electromagnetic radiation, **characterized in that** it comprises the steps of:
- arranging a diffusing element (24), so as to receive the electromagnetic radiation focused by said first focusing means (23) and to reflect said electromagnetic radiation; and
- arranging said plurality of photovoltaic cells (12) so that they receive the electromagnetic radiation reflected by said diffusing element (24).

**18.** A method according to claim 17, further comprising the step of arranging second focusing means (25) for receiving an electromagnetic radiation reflected by said diffusing element (24) and focusing it towards said plurality of photovoltaic cells.

**Amended claims in accordance with Rule 137(2) EPC.**

**1.** A system for irradiating photovoltaic cells (12) with an electromagnetic radiation, comprising:

- a first supporting structure (21) configured to carry a plurality of photovoltaic cells (12);
- first focusing means (23) configured to receive and focus said electromagnetic radiation;
- a diffusing element (24) configured to receive the electromagnetic radiation focused by said first focusing means (23) and to reflect said electromagnetic radiation, said supporting structure (21) and said diffusing element (24) being reciprocally arranged so that the electromagnetic radiation reflected by said diffusing element (24) is directed towards said plurality of photovoltaic cells (12);

**characterized in that** it further comprises second focusing means (25) configured to receive and focus the electromagnetic radiation reflected by said diffusing element (24), said second focusing means (25) and said supporting structure (21) being reciprocally arranged so that the electromagnetic radiation focused by said second focusing means (25) is directed towards said plurality of photovoltaic cells.

**2.** A system according to claim 1, wherein said supporting structure (21) at least partially surrounds said diffusing element (24) and comprises a plurality of supporting elements (27), each configured to carry a corresponding photovoltaic cell (12) of said plurality; said supporting elements (27) being arranged around said diffusing element (24).

**3.** A system according to claim 1 or 2, wherein said first focusing means (23) have an optical axis $(B_F)$, and wherein said diffusing element (24) comprises a reflecting portion (30) configured for reflecting electromagnetic radiation, said reflecting portion (30) having a symmetry axis (B), essentially coinciding with said optical axis.

**4.** A system according to claim 3, wherein said first focusing means (23) have a focus plane, and said diffusing element (24) is placed at a distance $(x_1)$ from said first focusing means (23) so that said focus plane crosses said reflecting portion (30).

**5.** A system according to claim 3 or 4, wherein said reflecting portion (30) has a shape chosen between: cone and polygonal based pyramid.

**6.** A system according to any of the claims from 3 to 5, wherein said reflecting portion (30) is formed by a ceramic material and is coated with a material chosen between aluminium and gold.

**7.** A system according to any of the preceding claims, wherein said first supporting structure (21) presents a symmetry axis (B) and is configured to carry said plurality of photovoltaic cells (12) so that said photovoltaic cells are angularly equally-spaced and equidistant from said symmetry axis.

**8.** A system according to any of the preceding claims, further comprising a second supporting structure (22), configured to carry said second focusing means (25) so that they are arranged between said diffusing element (24) and said supporting structure (21).

**9.** A system according to claim 8, wherein said first (21) and second (22) supporting structures are configured so that said photovoltaic cells (12) essentially lay on focus planes of said second focusing means (25).

**10.** A system according to claim 8 or 9, wherein said first (21) and second (22) supporting structures define cavities (40) coated with a reflecting material and each accommodating a corresponding photovoltaic cell (12) of said plurality.

**11.** A system according to any of the preceding claims, wherein said second focusing means (23) comprise any of: focusing lenses, field flattening lenses or waveguides; and wherein said first focusing means (23) comprise any of: a Fresnel lens, a prismatic lens, an optical meniscus.

**12.** A photovoltaic module (20) comprising: a system for irradiating photovoltaic cells (12) with an electromagnetic radiation according to any of the preceding claims, and a plurality of photovoltaic cell (12) carried by said system.

**13.** A photovoltaic module according to claim 12, wherein said photovoltaic cells (12) are of the multi-junction type.

**14.** A photovoltaic module according to claim 12 or 13, further comprising a container (45), said first supporting structure (21) being arranged inside said container (45) so that a gap (48) is present between said first supporting structure and said container, said gap being configured to contain a liquid.

**15.** A photovoltaic module according to claim 12 or 13, further comprising a plurality of heat sinks (55) and a heat pump, each heat sink being associated to a corresponding photovoltaic cell (12) of said plurality of photovoltaic cells, and said heat pump being operatively coupled to said heat sinks (55).

**16.** A method for irradiating photovoltaic cells (12) with an electromagnetic radiation, comprising the step of:

- arranging first focusing means (23) for receiving and focusing said electromagnetic radiation;
- arranging a diffusing element (24), so as to receive the electromagnetic radiation focused by said first focusing means (23) and to reflect said electromagnetic radiation; and
- arranging said plurality of photovoltaic cells (12) so that they receive the electromagnetic radiation reflected by said diffusing element (24);

**characterized in that** it further comprises the step of arranging second focusing means (25) for receiving an electromagnetic radiation reflected by said diffusing element (24) and focusing it towards said plurality of photovoltaic cells.

## FIG. 1

## FIG. 2

## FIG. 3

# FIG. 4

# FIG. 6a   FIG. 6b

FIG. 5

## FIG. 7

## FIG. 9

# FIG. 8

**EUROPEAN SEARCH REPORT**

Application Number

EP 09 42 5024

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/213514 A1 (ORTABASI UGUR [US]) 20 November 2003 (2003-11-20) | 1-6,13, 15-17 | INV. H01L31/052 |
| Y | * paragraphs [0034] - [0042], [0058] - [0064]; figures 1a,5,10a * | 7-12,14, 18 | |
| X | EP 0 116 521 A (MANISCALCO GASPARE) 22 August 1984 (1984-08-22) * pages 3-8; figures 1,2 * | 1-4,17 | |
| Y | EP 1 693 901 A (BIUCCHI SERGIO [IT]; MANTOVANI MARCO [IT]) 23 August 2006 (2006-08-23) * pages 16-21; figures 1-3 * | 7-12,14, 18 | |
| A | WO 2009/008996 A (RENSSELAER POLYTECH INST [US]; DUTTA PARTHA [US]) 15 January 2009 (2009-01-15) * abstract; figure 8 * | 1 | |
| E | US 2009/032085 A1 (GRUMAZESCU MIHAI [CA]) 5 February 2009 (2009-02-05) * abstract; figure 1 * | 1 | TECHNICAL FIELDS SEARCHED (IPC) H01L |

The present search report has been drawn up for all claims

| Place of search | Date of completion of the search | Examiner |
|---|---|---|
| Berlin | 4 June 2009 | Chao, Oscar |

## ANNEX TO THE EUROPEAN SEARCH REPORT
## ON EUROPEAN PATENT APPLICATION NO.

EP 09 42 5024

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2009

| Patent document cited in search report | | Publication date | Patent family member(s) | Publication date |
|---|---|---|---|---|
| US 2003213514 | A1 | 20-11-2003 | NONE | |
| EP 0116521 | A | 22-08-1984 | NONE | |
| EP 1693901 | A | 23-08-2006 | NONE | |
| WO 2009008996 | A | 15-01-2009 | NONE | |
| US 2009032085 | A1 | 05-02-2009 | NONE | |

EPO FORM P0459

For more details about this annex : see Official Journal of the European Patent Office, No. 12/82